Europäisches Patentamt

European Patent Office

Office européen des brevets

(11) Publication number: **0 252 173**
**A1**

(12) **EUROPEAN PATENT APPLICATION**

(21) Application number: 86109269.0

(22) Date of filing: 07.07.86

(51) Int. Cl.⁴: **H01L 29/80** , H01L 29/64 , H01L 29/52 , H01L 29/10 , H01L 21/76 , H01L 21/265 , H01L 21/28 , H01L 27/14 , H01L 29/56

(43) Date of publication of application:
13.01.88 Bulletin 88/02

(84) Designated Contracting States:
DE FR GB NL

(71) Applicant: **AMERICAN TELEPHONE AND TELEGRAPH COMPANY**
**550 Madison Avenue**
**New York, NY 10022(US)**

(72) Inventor: **Hwang, James Cheng-Min**
**3948 Willowbrook Lane**
**Liverpool New York, 13088(US)**

(74) Representative: **Blumbach Weser Bergen Kramer Zwirner Hoffmann Patentanwälte**
**Radeckestrasse 43**
**D-8000 München 60(DE)**

(54) Vertical field effect transistor.

(57) A vertical field effect transistor (FET) (e.g., 20) disclosed which has a relatively short channel length and which reduces parasitic capacitance without employing a mesa isolation technique. A short channel length is achieved as a consequence of the fact that the source electrode (e.g., 56) of the FET is used as an etching and shadow mask to form two gate electrodes (e.g., 62), on the opposite sides of the source electrode, which are aligned with the sides of the source electrode. Parasitic capacitance is reduced because two of the contact pads (e.g., 82 and 84) of the FET are formed on a region of the semiconductor body (de.g., 24) of the FET whose electrical resistivity has been increased through the implantation of appropriately chosen ions.

FIG. 7

## VERTICAL FIELD EFFECT TRANSISTOR

### 1. Field of the Invention

The invention pertains generally to semiconductor devices and, more particularly, to field effect transistors.

### Art Background

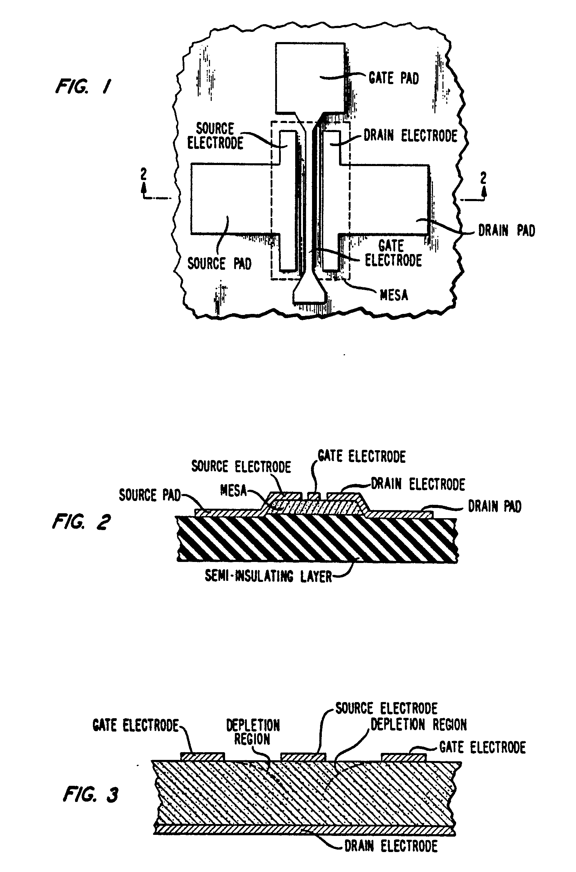

Horizontal and vertical field effect transistors (FETs) are known. In a typical horizontal FET, depicted in FIGS. 1 and 2 (FIG. 1 being a top view of a horizontal FET and FIG. 2 being a cross section taken along the line 2-2 of FIG. 1), a source electrode, a gate electrode, and a drain electrode are all arranged on the same major surface of a semiconductor body, with the gate electrode arranged between the source electrode and the drain electrode. The semiconductor body is usually a relatively thin (about 0.2 $\mu$m to about 2 $\mu$m thick) layer of semiconductor material which is typically epitaxially grown on a semi-insulating layer.

If, for example, the relatively thin layer of semiconductor material is of n-type conductivity, then the application of a forward-biasing voltage between the source and drain electrodes (biasing the drain electrode positively with respect to the source electrode) results in a current made up largely of electrons (the majority charge carriers in the n-type semiconductor layer) flowing through the horizontal current channel (as viewed in FIG. 2) between the source and drain electrodes. By applying a reverse-biasing voltage to the gate electrodes (biasing the gate electrode negatively with respect to the source electrode), a depletion region extends into the channel beneath the gate electrode, reducing the effective thickness of the channel. If the magnitude of the applied gate voltage is sufficiently high, the depletion region will pinch off the channel and thus stop current flow through the channel.

In general, the shorter the length of the current conducting channel, the higher the upper limit on the speed of operation of the horizontal FET because short channel lengths imply short transist time delays for the movement of charge carriers in the channel. The present-day feature resolution and alignment limitations of photolithography (using commercially available photoresists and conventional exposure systems) limit the minimum channel length that can be achieved with horizontal FETs to about 3 $\mu$m, thus limiting the speed of operation of horizontal FETs.

Capacitance also has a strong effect on the speed of FETs and influences the design of FETs. The electrical signals involved with the source, drain and gate electrodes of a horizontal FET are accessed through relatively large source, drain and gate pads, as is shown in FIG. 1. To reduce the parasitic capacitance associated with these pads and the resulting limitation on speed, a mesa isolation technique is typically used. In accordance with this technique, and as shown in FIG. 2, the sides of the relatively thin semiconductor layer of the horizontal FET are milled down to the semi-insulating layer to define a mesa. The source, gate, and drain electrodes are arranged on the mesa, which constitutes the active region of the horizontal FET. Parasitic capacitance is reduced because the source pad, gate pad, and drain pad are arranged on the upper surface of the electrically inactive semi-insulating layer, adjacent the mesa.

The height of the mesa typically ranges from about 0.2 $\mu$m to about 2 $\mu$m. This elevation necessitates the use of relatively wide metallic strips (wide compared to the lateral dimensions of the electrodes) extending over the sloping sides of the mesa to connect the pads to the electrodes, as shown in FIGS. 1 and 2. Narrow strips are precluded because of the strictures of photolithographic techniques and because narrow strips are often either too resistive or too fragile. The relatively wide metallic strips employed produce additional parasitic capacitance. Vertical FETs have been investigated in an attempt to avoid the limitations on speed encountered with horizontal FETs. In a typical vertical FET, as depicted in FIG. 3, the source and drain electrodes are arranged on the opposed major surfaces of a semiconductor body whose thickness, and thus the length of whose vertical current channel, can be made as small, as or even less than, 1 $\mu$m.

Often, portions of the semiconductor body of a vertical FET, adjacent the source and drain electrodes, are appropriately doped to form ohmic contacts (contacts which display a generally linear current-voltage relationship over the operating range and whose resistance to current flow is low compared to the resistance of the current channel) between these electrodes and the underlying semiconductor material. The source or drain electrode, in combination with its adjacent doped region, is referred to as the source or drain, respectively.

Additionally, two gate electrodes are arranged on one of the major surfaces of the semiconductor body on opposite sides of the source or drain electrode (in FIG. 3 the gate electrodes are on opposite sides of the source electrode).

The vertical current channel extending from the source electrode (or source) to the drain electrode (or drain) is pinched off by intersecting depletion regions extending laterally from beneath each of the gate electrodes. The present-day resolution and alignment limitations of conventional near ultraviolet photolithography limit the minimum channel thickness (the distance between the gate electrodes) of a vertical FET to at least $3\mu m/$ Consequently, the lateral dimension of the depletion region generated beneath each gate electrode must be at least 1.5 $\mu m$ in order to pinch off the vertical current channel.

It is believed that the depletion regions generated beneath the gate electrodes of a vertical FET grow generally isotropically. Thus, the vertical dimension of each depletion region at pinch-off will also be about 1.5 $\mu m$. However, if the depletion regions contact the drain electrode or drain, then undesirable breakdown currents may flow between the gate electrodes and the drain electrode or drain. To avoid these breakdown currents the thickness of the semiconductor body, and the length of the vertical current channel, is made greater than 1.5 $\mu m$. Thus, the present-day resolution and alignment limitations of photolithography limit the minimum channel lengths of most vertical FETs to no less than 1.5 $\mu m$.

A vertical FET having a relatively short channel length is disclosed in U.S. Patent Number 4,326,166 to Cho et al. In addition to source, drain, and gate electrodes, the Cho et al device includes a mesa of, for example, $10^+$-gallium arsenide, which is grown on an active layer, such as an n-aluminum gallium arsenide layer, which overlies a layer such as an $n^+$-gallium arsenide layer. After the mesa is epitaxially grown on the aluminum gallium arsenide active layer, the large difference in etch rates between gallium arsenide and aluminum gallium arsenide in various etchants is exploited to form the mesa by using the aluminum gallium arsenide active layer as a stop-etch layer. (Cho et al suggest that the etchants used to form the mesa could be utilized to cause the mesa to undercut the drain electrode, allowing the resulting overhang to be used as a shadow mask to evaporate self-aligned gate electrodes onto the upper surface

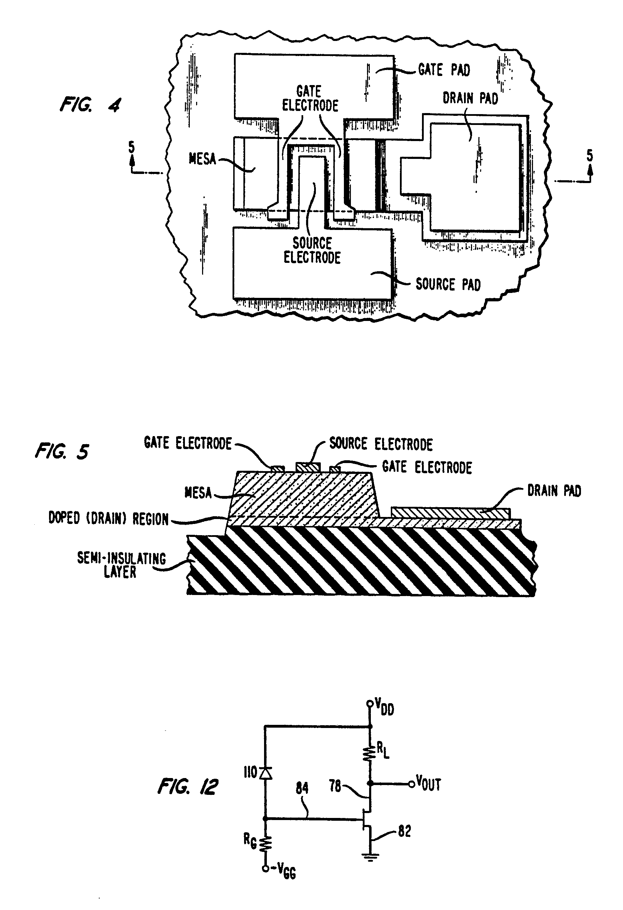

Although the Cho et al device is exemplary, as with other proposed vertical FETs, the use of a mesa isolation technique to avoid the effect of parasitic capacitance is generally not entirely desirable. To produce isolation it would be necessary to mill down the sides of the semiconductor body from one major surface to the opposed major surface in order to form an appropriate, isolating mesa structure as shown, for example, in FIGS. 4 and 5 (FIG. 4 being a top view of a mesa-isolated vertical FET and FIG. 5 being a cross section taken along the line 5-5 of FIG. 4). As noted above, vertical FETs typically have semiconductor bodies whose thicknesses must generally by greater than 1.5 $\mu m$. It would be difficult, using standard photolithography, to lay down narrow (to reduce parasitic capacitance), connecting metallic strips over the inclined sides of a mesa having so great a height, or even a smaller height. Thus, in order to bridge the elevational gap between the active and inactive regions, relatively wide strips would have to be used with a concomitant increase in parasitic capacitance. For example, and as shown in FIG. 4, the width of the source electrode then extended over the side of the mesa to the source pad. However, increasing the width of the source electrode requires an increase in the spacing between the gate electrodes, and thus an increase in the thickness of the current channel. But an increase in channel thickness necessitates an increase in channel length to avoid adverse breakdown currents between the gate electrodes and the drain). Consequently, the use of a mesa isolation technique with a vertical FET results in an increased channel length and thus a decrease in speed.

Therefore, an important objective of those engaged in the development of high-speed vertical FETs is the development of a vertical FET which has both a relatively short channel length and means to reduce parasitic capacitance.

## Summary of the Invention

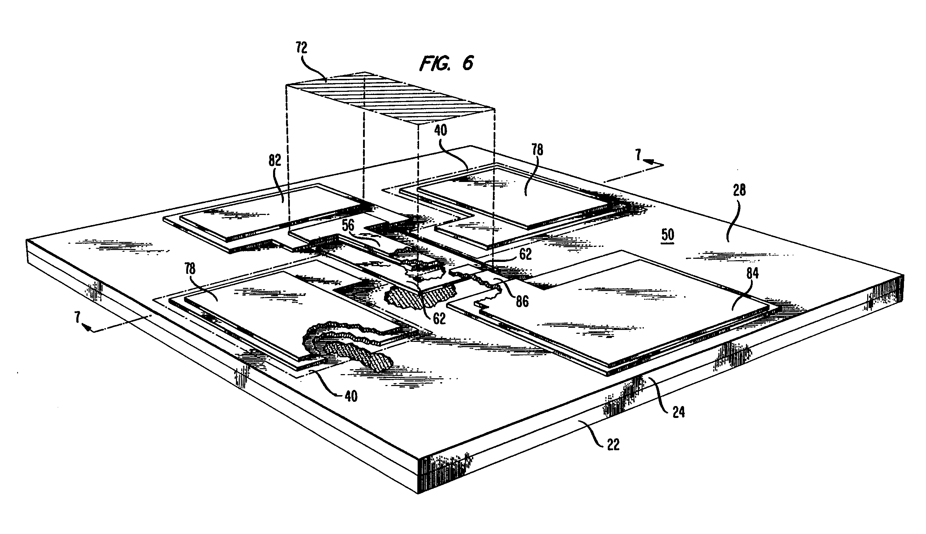

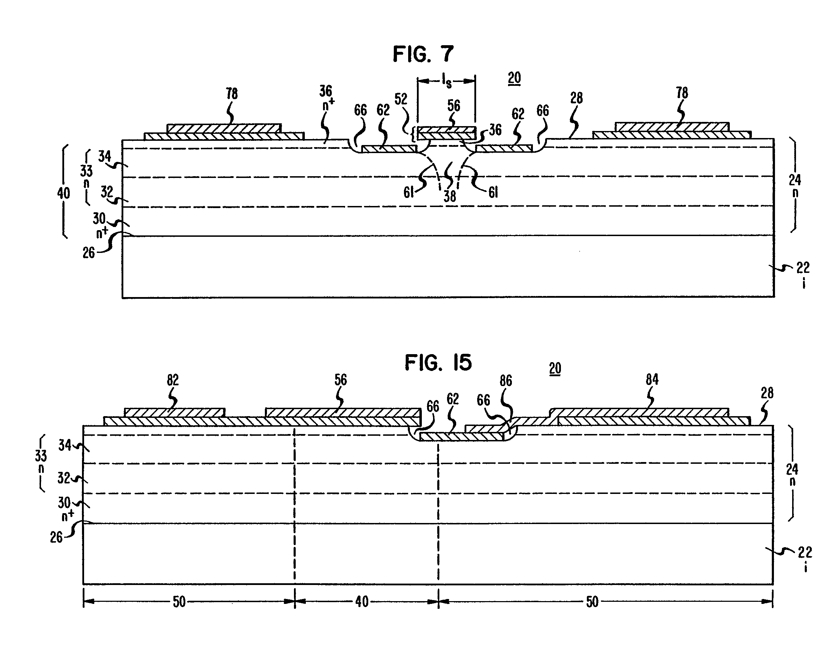

The invention is a vertical FET which has both a relatively short channel length (less than 1 $\mu m$) and means to reduce parasitic capacitance without the difficulties associated with the use of a mesa. A relatively short channel length is achieved with the inventive vertical FET because, during fabrication, the source electrode 56 (or drain electrode) of the device (see FIGS. 6 and 7) is used as an etch mask to form two channels 66 on the opposite sides of the electrode, each channel undercutting the electrode. Thereafter, the source (or drain) electrode is used as a shadow mask during the metallization (or doping) of the channels, to form two metallized (or two p-n junction) gate electrodes 62 within the channels, which gate electrodes are immediately adjacent to, and vertically aligned with, the side of the source (or drain) electrode. Thus the thickness of the vertical current channel of the device, i.e., the distance between the gate electrodes, is approximately equal to the lateral size, $1_s$, of the source (or drain) electrode. Consequently, in order to avoid adverse breakdown currents between the gate electrodes and the drain (or source) of the device, the channel length of the device need only be greater than about $1_s/2$. For example, if the source (or drain) electrode of the invention is lithographically fabricated to have a lateral size of about 1 μm (which is presently achievable with photolithography), then the vertical current channel need only be a little greater than about 0.5 μm to avoid adverse breakdown currents.

The invention reduces parasitic capacitance by using a planar isolation technique which involves implanting ions into a region of the semiconductor body of the vertical FET in order to significantly increase the electrical resistivity of the implanted region. The vertical FET is then formed by fabricating the source (or drain) electrode, the two gate electrodes, and all of the contact pads (the source, drain, and gate pads) of the device on a surface of the semiconductor body which includes a surface of the implanted region as well as a coplanar surface of the nonimplanted region. However, two of the contact pads are formed on the surface of the implanted regions, which is an electrically inactive region, while the remaining contact pads and electrodes are formed on the surface of the nonimplanted region, which is the active region of the device. Thus, although the major elements of the invention are arranged on the same surface of the semiconductor body, two of the contact pads contribute little or nothing to parasitic capacitance.

The vertical FET of the present invention is also easily integrable with a photodiode to produce a photo-FET which amplifies an input signal into a large electrical signal.

Brief Description of the Drawing

Embodiments of the invention are described with reference to the accompanying drawings wherein like numerals denote like members, and wherein:

FIGS. 1 and 2 are, respectively, a top view and a cross-sectional view of a prior art horizontal FET;

FIG. 3 is a cross-sectional view of a prior art vertical FET;

FIGS. 4 and 5 are, respectively, a top view and a cross-sectional view of a prior art vertical FET which employs a mesa isolation technique to reduce parasitic capacitance;

FIGS. 6 and 8 are, respectively, perspective views of first and second embodiments of the vertical FET of the present invention, while FIGS. 7 and 15 and 9 and 16 are corresponding cross-sectional views of the two embodiments of the inventive vertical FET;

FIGS. 10 and 13 are perspective views of first and second embodiments of the photo-FET of the present invention, while FIGS. 11 and 17 and 14 and 18 are corresponding cross-sectional views of the two embodiments of the inventive photo-FET; and

FIG. 12 is a circuit diagram representation of the photo-FET shown in FIGS. 10, 11 and 17.

Detailed Description

The invention is a vertical FET which has a relatively short channel length (less than 1μm) and relatively low parasitic capacitance. With reference to FIGS. 6, 7 and 15, but particularly FIG. 7, a first embodiment of a vertical FET 20, according to the invention, includes a semiconductor body 24 arranged on a relatively thick (thick compared to the semiconductor body 24) insulating or semi-insulating layer 22. The relatively thick insulating or semi-insulating layer 22 serves to reduce the parasitic capacitance associated with the vertical FET 20. The semiconductor body 24 includes a first major surface 28 and a non-coplanar, second major surface 26 which is in contact with the insulating (or semi-insulating) layer 22. The second major surface 26 is preferably spaced from, and opposed to, the first major surface 28 (as shown in FIG. 7). In addition, the semiconductor body 24 includes a relatively heavily doped layer 30 (the dopant concentration in layer 30 is greater than, and preferably at least 100 times greater than, the generally uniform dopant concentration in the remainder of the semiconductor body 24), immediately adjacent the second major surface 26, which layer 30 constitutes the drain of the vertical FET 20.

The semiconductor body 24 is, for example, of n-type conductivity, e.g., GaAs doped with Si, while the layer 22 is preferably a semi-insulating layer, for example, GaAs doped with Cr. Preferably, the semiconductor body 24 is epitaxially grown on the semi-insulating layer 22 using, for example, molecular beam epitaxy which permits precise control of thickness and doping.

Arranged on the first major surface 28 of the semiconductor body 24 is a metallized source electrode 56. The source electrode 56 is fabricated by using, for example, conventional photolithographic techniques. At present, the feature resolution limitation of photolithography (using commercially available photoresists and conventional exposure systems) is about 1 μm, and thus the lateral size $1_s$, of the source electrode 56 is as small as about 1 μm. The current channel 38 of the vertical FET 20 extends vertically downwardly from the source electrode 56 through layer 33 of the semiconductor body 24 to the drain 30.

While not essential to the invention, the semiconductor body 24 preferably includes a relatively heavily doped layer 36, referred to here as the contact layer 36, immediately adjacent the first major surface 28 (as shown in FIG. 7). The doping level within the contact layer 36 is, for example, approximately equal to that within the drain 30. In this embodiment of the invention a low resistance contact (low compared to the electrical resistance of the vertical current channel 38), e.g., an ohmic contact, is formed between the source electrode 56 and the underlying portion of the contact layer 36. Thus, the source 52 of the vertical FET 20. Therefore, the vertical current channel 38 extends from beneath the source 52 to the drain 30 through the thickness of the active layer 33 (see FIG. 7), which layer 33 is sandwiched between the contact layer 36 and the drain 30.

One of the most significant features of the invention is the fact that a relatively short channel length is achieved with the vertical FET 20. This short channel length is a direct consequence of the inventive procedure used to fabricate two metallized gate electrodes 62 (see FIG. 7), on the opposite sides of the metallized source electrode 56. In accordance with this inventive fabrication procedure, and after the formation of the source electrode 56, and area 72 (the rectangular, cross-hatched area shown in FIG. 6) on the surface 28 is delineated by conventional lithographic techniques (for example, a layer of resist is deposited onto the surface 28, and a window is opened in the resist which exposes the area 72). The area 72, referred to here as the gate metal area 72, includes the area occupied by the source electrode 56. After being delineated, the gate metal area 72 is subjected to an etchant which etches the semiconductor body 24 both vertically and laterally (as viewed in FIG. 7), but does not significantly attack the source electrode 56. Thus, with the source electrode 56 acting as an etch mask which shields the underlying semiconductor material from the etchant, this etching procedure results in the formation of two channels 66 (see FIG. 7) on the opposite sides of the source electrode 56, each of which channels 66 undercuts the adjacent side of the source electrode 56. After being etched, the gate metal area 72 is metallized by conventional techniques such as evaporation. During this metallization procedure, the source electrode 56 acts as a shadow mask, shielding the underlying semiconductor material, including the undercutting portions of the channels 66, from metal deposition. Consequently, while metal is deposited onto the source electrode 56 (which is why the source electrode is shown as having two layers of metal in FIG. 7), the metal deposited into the channels 66 (which metal constitutes the gate electrodes 62) is vertically aligned with the sides of the source electrodes 56. Moreover, because the undercutting portions of the channels 66 are not metallized, there is no metal-to-metal contact between the gate electrodes 62 and the source electrode 56, precluding short circuits during the operation of the vertical FET 20. In addition, the thickness of the metal deposited onto the gate metal area 72, and thus into the channels 66, is less than the depth of the channels 66 to again prevent contact between the gate electrodes 62 and the source electrode 56.

The depth of the channels 66, formed during the etching procedure, extends through the thickness of the contact layer 36. The gate electrodes 62 in the channels 66 form rectifying contacts (contacts which exhibit a relatively low resistance to current flow in one direction, but a relatively high resistance in the opposite direction), i.e., Schottky barrier contacts (metal-semiconductor rectifying contacts), with the semiconductor material of the active layer 33.

Because the gate electrodes 62 are vertically aligned with the source electrode 56, the thickness of the vertical current channel 38, i.e., the distance between the gate electrodes 62, is approximately equal to the lateral size, $1_s$, of the source electrode 56. Consequently, in order to avoid adverse breakdown currents between the metallized gate electrodes 62 and the drain 30, the length of the current channel 38 (the distance from the source 52, for example, to the drain 30) need only be a little greater than $1_s/2$.

In an exemplary embodiment of the semiconductor body 24, the active layer 33 is preferably a moderately doped n-layer with a dopant concentration ranging from about $1 \times 10^{15}cm^{-3}$ to about $1 \times 10^{17}cm^{-3}$. Of the source electrode 56 is lithographically fabricated to have a lateral size of, for example, about 1 $\mu$m (which is presently achievable with, for example, photolithography), then the thickness of the active layer 33 (and thus the length of the current channel 38) ranges from about 0.6 $\mu$m to about 1 $\mu$m, and is preferably about 0.8 $\mu$m. Thickness smaller than about 0.6 $\mu$m are undesirable because they lead to adverse breakdown currents, while thicknesses greater than about 1 $\mu$m (while not excluded) produce undesirably long current channels.

In order to achieve a relatively low electrical resistance (low compared to that of the current channel 38), the drain 30 of the exemplary embodiment is preferably a relatively heavily doped $n^+$ layer whose doping level ranges from about $1 \times 10^{17}cm^{-3}$ to about $1 \times 10^{19}cm^{-3}$. Moreover, thickness of the drain 30 ranges from about 0.3 $\mu$m to about 3 $\mu$m, and is preferably about 1 $\mu$m. A thickness less than about 0.3 $\mu$m undesirably increases the resistance of the drain 30. A thickness greater than about 3 μm undesirably increases the difficulty of implanting ions through the thickness of the semiconductor body 24 to form an inactive region 50 (described below).

The contact layer 36 of the exemplary embodiment is preferably also an $n^+$ layer whose doping level ranges from about $1 \times 10^{17} cm^{-3}$ to about $1 \times 10^{19} cm^{-3}$. If the source electrode 56 is, for example, alloyed to produce a low resistance contact, then the contact layer 36 has a thickness of at least 0.1 μm to prevent metallic spikes (protruding from the alloyed source electrode 56) from extending into the active layer 33 (which results in undesirable breakdown currents between the metallic spikes and the gate electrodes 62 during the operation of the vertical FET 20). Because the thickness of the contact layer 36 should be less than the depth of the channels 66 (so that the metallized gate electrodes 62 in the channels 66 form Schottky barrier contacts with the semiconductor material of the active layer 33), and because the depth of the channels 66 is preferably less than about 0.4 μm, the thickness of the contact layer 36 is preferably no greater than about 0.3 μm.

The channels 66 of the exemplary embodiment have a depth which ranges from about 0.2 μm to about 0.4 μm, and is preferably about 0.3 μm. A depth less than about 0.2 μm is undesirable because then the depth of the channels 66 may not extend through the thickness of the contact layer 36. If, for example, the channels 66 are isotropically etched, then a depth greater than about 0.4 μm implies that each side of the source electrode 56 will also be undercut by about 0.4 μm, decreasing the thickness, and thus undesirably increasing the resistance, of the vertical current channel 38.

With reference once again to FIG. 7, the semiconductor body 24 of the vertical FET 20 preferably includes a vertical dopant concentration gradient within the active layer 33. (The dopant concentration within the layer 33 should increase as one moves vertically from the drain 30 toward the source 52.) It has been found that such a dopant concentration gradient is advantageous because it results in an increase in the breakdown voltage between the gate electrodes 62 and the drain 30. Thus, even if the depletion regions generated beneath the gate electrodes 62 should contact the drain 30, the likelihood that breakdown currents will flow between the gate electrodes 62 and the drain 30 is reduced. A dopant concentration gradient is achieved, for example, by forming two discrete layers, denoted 32 and 34 in FIG. 7, having different dopant concentrations, in place of the single active layer 33. When incorporated into the exemplary embodiment, the layer 32 is preferably a relatively lightly doped $n^-$-layer with a dopant concentration ranging from about $1 \times 10^{13} cm$-3 to

about $1 \times 10^{15} cm^{-3}$. The greater the thickness of the layer 32, the greater is the breakdown voltage between the gate electrodes 62 and the drain 30. However, while a relatively thick layer 32 is obviously desirable, the thickness of the layer 32 is preferably no greater than about 1 μm to avoid an undesirably long current channel 38.

The layer 34, on the other hand, is preferably a moderately doped n-layer with a dopant concentration ranging from about $1 \times 10^{15} cm$-3 to about $1 \times 10^{17} cm$-3. The thickness of the layer 34 ranges from about half the thickness of the current channel 38 to about 1 μm, and is preferably about 1 μm. A thickness smaller than about half the thickness of the current channel 38 is undesirable because then the depletion regions generated by the gate electrodes 62 grow faster in the vertical direction (as viewed in FIG. 7) than in the lateral direction, increasing the likelihood that the depletion regions will contact the drain 30 and cause breakdown currents between the gate electrodes 62 and the drain 30. A thickness greater than about 1 μm is undesirable because such a thickness results in a undesirably long current channel 38.

Another very significant feature of the invention is that while the electrical signals associated with the source and gate electrodes 56 and 62, and drain 30, are accessed through conventional contact pads, the parasitic capacitance associated with the contact pads is reduced not by means of a mesa isolation technique, but rather by means of an inventive planar isolation technique. In accordance with this planar isolation technique, as as shown in FIG. 6, all of the contact pads are formed on the surface 28 of the semiconductor body 24, the very same surface on which the source and gate electrodes are formed. However, in order to reduce parasitic capacitance, the source pad 82 (connected to the source electrode 56) and the gate pad 84 (connected to the two gate electrodes 62) are formed on a portion of the surface 28 overlying an electrically inactive region of the semiconductor body 24 denoted by the numeral 50. The source electrode 56, the two gate electrodes 62, and the drain pad 78 (preferably there are two drain pads 78, as shown in FIG. 6), on the other hand, are formed on a different portion of the surface 28 overlying an electrically active region 40 (the generally z-shaped region outlined by the dash-dot line in FIG. 6) of the semiconductor body 24. (In practice, the surface of the inactive region 50 is etched about 100 nm below the surface of the active region 40 in order to be able to distinguish the two regions during processing. For purposes of the invention, the surfaces of the two regions are considered to be substantially coplanar and included within the first major surface 28.)

The electrically inactive region 50 extends from the first major surface 28 of the semiconductor body 24 toward, and preferably to, the second major surface 26. The greater the depth of the electrically inactive region 50, the greater is the reduction in the parasitic capacitance associated with the source pad 82 and gate pad 84. The active region 40 also extends from the first major surface 28 to the second major surface 26.

The region 50 is made electrically inactive by implanting ions into the region 50 which increase the resistivity of the region 50. In order to adequately reduce parasitic capacitance, the ions are choses to increase the resistivity of the inactive regions 50 at least 10,000-fold over the resistivity of the active region 40. The useful ion-implantation conditions, i.e., the ion species, ion energies, and ion dosages which will produce a 10,000-fold increase in resistivity, vary depending on the particular semiconductor material of the semiconductor body 24, the thickness of the semiconductor body 24, and the dopant concentration gradients within the semiconductor body 24. Preferably, the ions should be sufficiently energetic to displace atoms within the lattice structure of semiconductor material, through the entire thickness of the semiconductor body 24 (see, e.g., J. F. Gibbons et al, Projected Range Statistics, Semiconductors and Related Materials (Dowden, Hutchinson and Ross, Stroudsburg, Pennsylvania, 1975), concerning the depth of penetration of various ions into various semiconductor material).

In general, the appropriate ion implantation conditions are determined empirically. Thus, in fabricating the present invention, a control sample of the semiconductor material used in the vertical FET 200 is deposited on an insulating (or semi-insulating) layer, implanted with ions, and the resulting increase in the resistivity of the implanted control sample is measured. This measurement is made, for example, by lithographically fabricating two contact pads on the surface of the control sample, applying a known voltage difference across the contact pads, and measuring the resulting leakage current between the contact pads. The voltage difference and leakage current define the resistance of the semiconductor material between the contact pads, from which the resistivity of the semiconductor material is inferred.

If, for example, the semiconductor body 24 is of Si-doped GaAs, then useful, resistivity-increasing ions include $O^1$ ions and $H^+$ ions. In particular, if the semiconductor body 24 is of Si-doped GaAs and has the exemplary structure described above, then it has been found (using the above-described empirical procedure) that a 10,000-fold increase in resistivity is achieved if two different sets of $O^1$ ions are implanted into the inactive region 50. The first set of $O^1$ ions has energies of 600-800 keV and is implanted at dosages of $1 - 3 \times 10^{12} cm^{-2}$. The second set of $O^{-1}$ ions has energies of 2.5 - 3.5 MeV and is implanted at dosages of $1 - 3 \times 10^{13} cm^{-2}$. Alternatively, if $H^+$ ions are used, then they are implanted of $0.5 - 2 \times 10^{14} cm^{-2}$.

For purposes of illustration only, the electrode 56 of the vertical FET 20, described above, has been denominated a source electrode, and the heavily doped layer 30 has been denominated a drain. However, the vertical FET 20 can just as readily be operated so that the source electrode 56 (or source 52) functions as the drain electrode (or drain), and the layer 30 functions as the source. Thus, the two contact pads 78 would then function as source pads, and the contact pad 82 would then function as the drain pad.

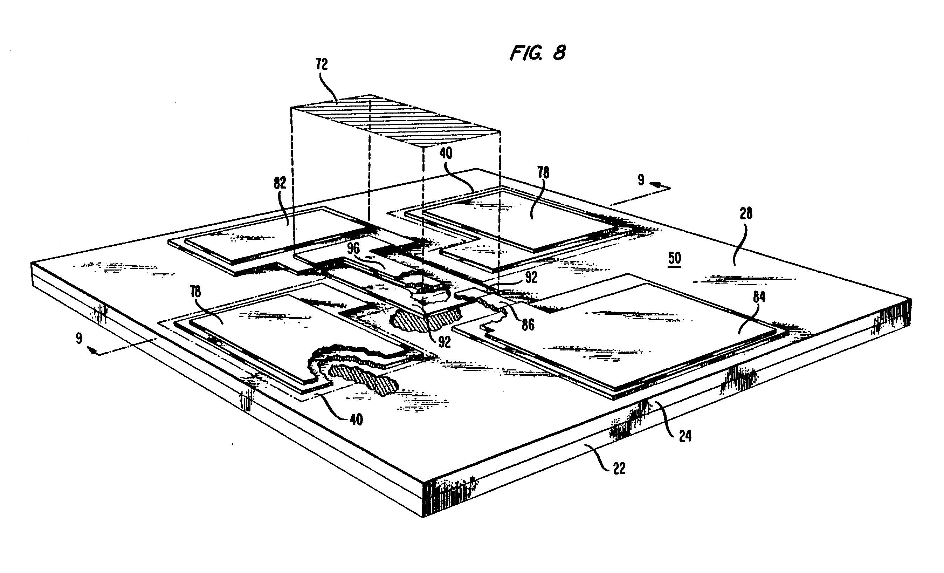

With references to FIGS. 8, 9 and 16, a second embodiment of the vertical FET 20 is structurally identical to the first embodiment in all but two respects. First, a metallized drain electrode 96 is provided in place of the source electrode 56. The metallized drain electrode 96 forms a rectifying contact, i.e., a Schottky barrier contact, with the underlying semiconductor material. (During operation, the Schottky barrier drain electrode 96 functions as a forward-biased Schottky contact). In this second embodiment, the relatively heavily doped layer 30 immediately adjacent the second major surface 26 of the semiconductor body 24 constitutes the source of the vertical FET 20. Thus, the vertical current channel 38 of the second embodiment extends from the source 30 to the drain electrode 96.

The second embodiment of the vertical FET 20 also differs from the first embodiment in that two p-n junction gate electrodes 92 are formed in the two channels 66 on the opposite sides of the drain electrode 96, in place of the metallized, Schottky barrier gate electrodes 62 of the first embodiment. The p-n junction gate electrodes 92 are formed by first etching the gate metal area 72, and then doping the gate metal area 72 with an opposite-conductivity dopant, i.e., a dopant which produces a conductivity of opposite type to that of the semiconductor body 24, while using the drain electrode 96 as an etching and shadow mask. The penetration depth of the opposite-conductivity dopant is small compared to the depth of the channels 66. A layer of metal is also deposited onto the gate metal area 72, and thus into each of the channels 66. This metal is preferably chosen to form a low resistance contact, e.g., an ohmic contact, with the underlying semiconductor material doped with the opposite-conductivity dopant. The layer of metal in each of the channels 66 provides a conductive path for communicating a voltage signal to the underlying p-n junction. In order to avoid metal-to-metal contact between the gate electrodes 92 and the drain electrode 96, the thickness of the metal deposited onto the gate metal area 72 (and thus into the channel 66) is less than the depth of the channels 66.

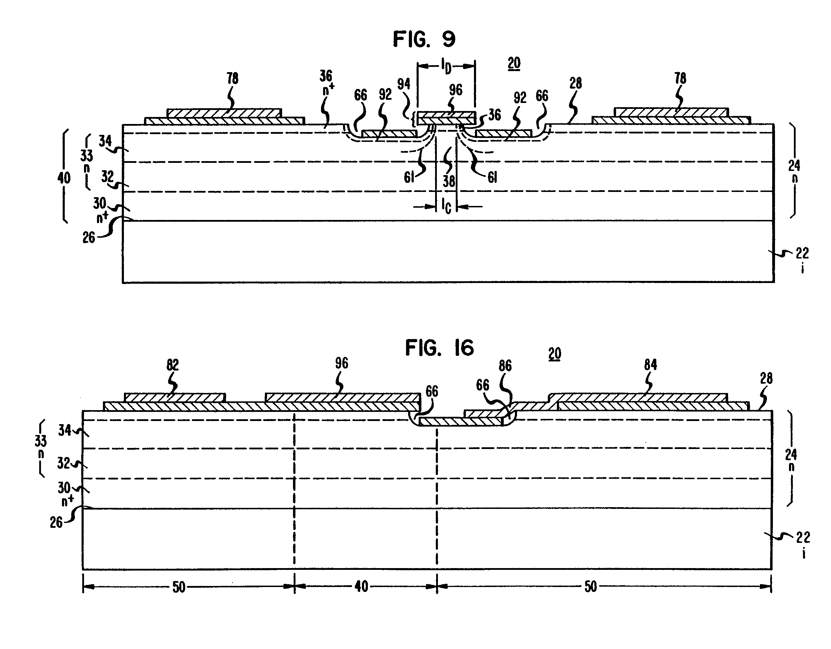

It should be noted that in the second embodiment of the vertical FET 20, the thickness of the vertical current channel 38 (see FIG. 9) is even less than the lateral size, $1_D$, of the drain electrode 96. This is due to the face that the portions of the channels 66 which undercut the drain electrode 96 also get doped (during the doping process) with the opposite-conductivity dopant, effectively reducing the thickness of the current channel 38 to the lateral distance, $1_C$, between the doped channels 66 (as measured just beneath the drain electrode 96). Thus, in order to avoid adverse breakdown currents between the gate electrodes 92 and the source 30, the length of the current channel 38 need only be slightly greater than about $1_C/2$.

If the semiconductor body 24 is of n-type conductivity, e.g., GaAs doped with Si, then the drain electrode 96 is preferably of tungsten and the opposite-conductivity dopant, i.e., the p-type dopant, diffused into the channels 66 is, for example, zinc. Tungsten is preferred because if forms a Schottky barrier contact with Si-doped GaAs and can withstand the high temperature associated with the diffusion of the zinc into the channels 66.

The electrodes, the contact pads, and the gate metal areas shown in FIGS. 6-9 have been pictured as being generally rectangular in shape and/or cross section. However, other shapes are also useful. In addition, the active region 40 shown in FIGS. 6 and 8 has been pictured as being generally z-shaped in outline. Again, other shapes are also useful for the active region 40.

Both the first and second embodiments of the vertical FET 20 have also been described as having but one source or one drain electrode, with two gate electrodes on the opposite sides of the single source or drain electrode. But both embodiments can, in fact, include a plurality of source or drain electrodes arranged adjacent one another, and generally parallel to one another, with a plurality of gate electrodes interdigitated between the source or drain electrodes. To ensure that there is a gate electrode adjacent each side of each source or drain electrode, the number of gate electrodes should be greater by one than the number of source or drain electrodes.

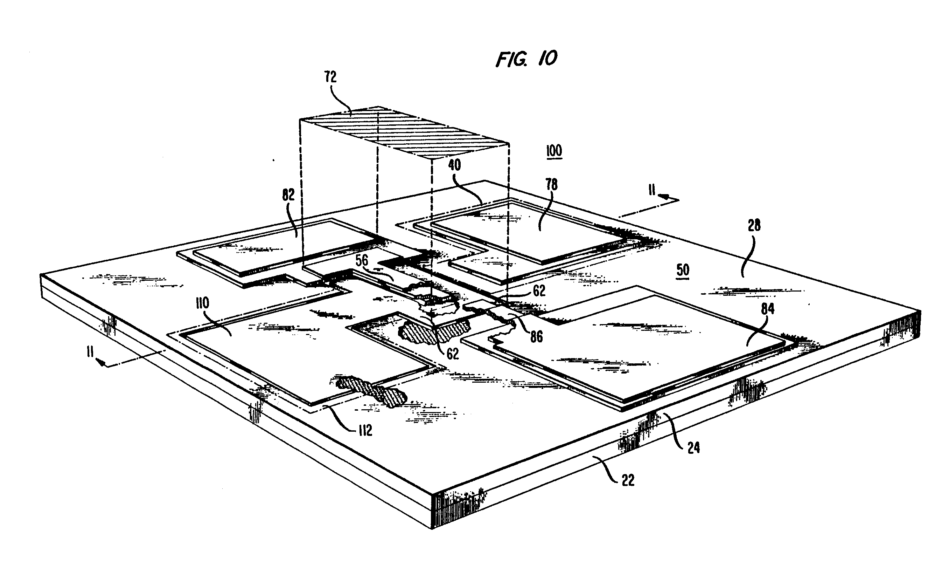

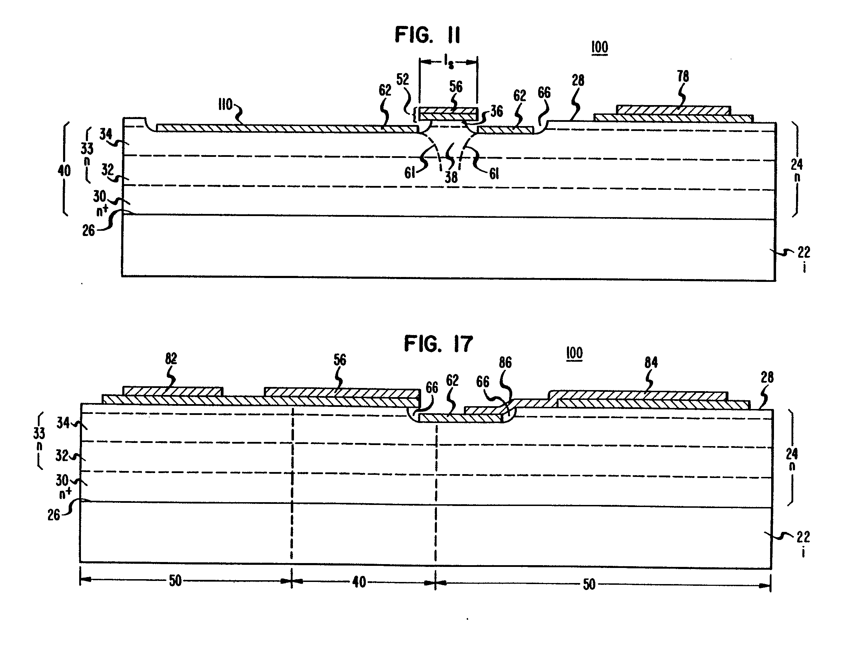

Yet another significant feature of the invention is that because of its layout and design, the vertical FET 20 is readily integrated with a photodiode to form a photo-FET, i.e., a FET which produces an electrical signal in response to a light signal. As shown in FIGS. 10 and 11, a first embodiment of a photo-FET 100 encompassed by the invention differs from the first embodiment of the vertical FET 20 only in that one of the two metallized drain pads 78 is replaced by a metallized photodiode 110 which is electrically connected to the two gate electrodes 62. The photodiode 110 includes a relatively thin layer of metal (thin compared to the thickness of the source and gate electrodes and contact pads) on the active region 40. The metal of the photodiode 110 forms a rectifying contact, i.e., a Schottky barrier contact, with the underlying semiconductor material (of the active region 40) and is at least partially transparent to incident electromagnetic radiation of interest (at least 50 percent of the incident electromagnetic radiation penetrates the relatively thin layer of metal to reach the underlying semiconductor material).

The procedure for fabricating the first embodiment of the photo-FET 100 differs from the fabrication procedure for the first embodiment of the vertical FET 20 only in that after the source electrode 56 has been formed, both a gate metal area 72 and a contiguous photodiode area 112 (the photodiode area 112 is the area on the active region 40 to be occupied by the photodiode 110) is lithographically delineated. The two delineated areas are then etched and metallized (using the source electrode 56 as an etching and shadow mask) to form the two metallized gate electrodes 62 and the metallized photodiode 110. Because the photodiode are 112 is contiguous to the gate metal area 72, the metallized photodiode 110 extends continuously from one of the two metallized gate electrodes 62. Thereafter, just the gate metal area 72 is lithographically delineated and metallized, resulting in the deposition of additional metal onto the gate electrode 62 and onto the source electrode 56 in order to thicken and thus reduce the resistances of these electrodes.

If, for example, the semiconductor body 24 of the photo-FET 100 is of GaAs doped with SI, then the metal used to form the photodiode 110 is, for example, a layer of A1. The thickness of the A1 ranges from about 5 nm to about 10 nm and is preferably about 10 nm. The A1 forms a Schottky barrier contact with the semiconductor material (Si-doped GaAs) of the active region 40, and is at least partially transparent to both visible and near infrared light, i.e., light having a wavelength ranging from about 400 nm to about 1500 nm. A thickness of the A1 layer less than about 5 nm is undesirable because the A1 layer is likely to be both physically and electrically discontinuous. On the other hand, a thickness of the A1 layer greater than about 20 nm is undesirable because a relatively small amount of electromagnetic radiation (smaller than about 50 percent) will penetrate the A1 layer.

As with the vertical FET 20, the photo-FET 100 is operated in either a normally-on mode (see S. M. Sze, Physics of Semiconductor Devices (Wiley, New York, 1981), pp. 322-324) or a normally-off mode. With reference to FIGS. 11, 17 and 12, in the normally-off mode of operation, for example, the source pad 82 is grounded and a positive, forward-biasing supply voltage $V_{DD}$ is applied to the single drain pad 78. However, no current flows between the source electrode 56 (or source 52) and drain 30 because a negative (with respect to the source pad 82), reverse-biasing voltage -$V_{GG}$ of sufficiently large magnitude is applied to the gate pad 84 in order to generate depletion regions beneath each gate electrode 62 which just pinch off the current channel 38.

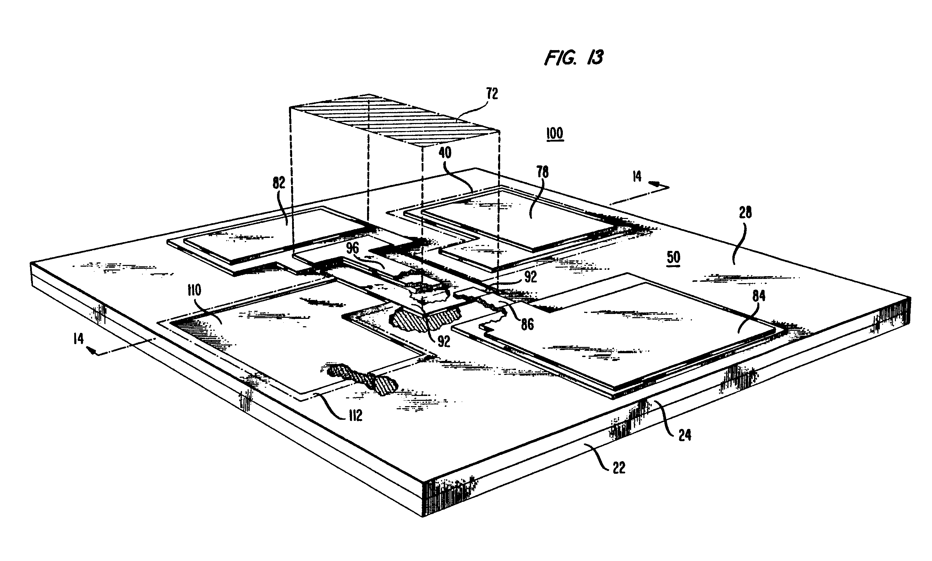

When light is shined on the photo-FET 100, little or no light penetrates the relatively thick metal of the source electrodes 56, the gate electrodes 62, and the drain pad 78. However, at least some light (at least 50 percent of the incident light) penetrates the relatively thin metal of the photodiode 110, producing hole-electron pairs within the underlying semiconductor body 24. Under the influence of the reverse-biasing gate voltage -$V_{GG}$, positively charged holes move vertically upwardly (as viewed in FIG. 11) toward the thin metal layer of the photodiode 110, while negatively charged electrons move downwardly toward the positively biased drain 30. Hence, a current $i$ flow vertically through the photodiode 110. If a resistor, of resistance $R_G$, is placed in the circuit between the gate pad 84 and the gate bias supply -$V_{GG}$, as shown in FIG. 12, then current $i$ also flows through the resistor of resistance $R_G$4, and thus a voltage drop of $i \times R_G$ occurs across the resistor. Because the photodiode 110 is electrically connected to the gate electrodes 62, the voltage communicated to the gate electrodes 62 is approximately -$V_{GG}$ + ($i \times R_G$), which is less of a reverse-biasing voltage then needed to pinch off the current channel 38. Consequently, the vertical current channel 38 opens up and current flows through the channel.

If a load resistor, of fixed resistance $R_L$, is placed in series between the drain pads 78 and the drain bias $V_{DD}$, as is shown in FIG. 12, then the voltage drop across the load resistor is normally zero with the photo-FET off because no current flows between the source electrode 56 (or source 52) and drain 30. Thus a voltage output, $V_{out}$, sensed at the gate pad 78, is normally approximately equal to $V_{DD}$. However, when light is shined on the photo-FET 100, and the voltage communicated to the gate electrodes 62 changes from -$V_{GG}$ to -$V_{GG}$ + ($i \times R_G$), as described above, then a current ($i \times R_G$) ($g_m$) flows through the vertical FET 20, $g_m$ being the transconductance of the vertical FET 20. (The transconductance, $g_m$, denotes the ratio of the change in the current flowing through the channel 38 to the current-inducing change in voltage communicated to the gate electrodes 62.) The induced current in the vertical FET 20 implies that there is a corresponding voltage drop ($i \times R_G$) ($g_m$) ($R_L$) across the load resistor, and a corresponding decrease in the voltage output, $V_{out}$, at the gate pad 78, i.e.,

$V_{out} = V_{DD} - (i \times R_G) (g_m) (R_L)$.

Because the transconductance, $g_m$, of the vertical FET 20 of the photo-FET 100 is greater than 1 (as is typical of FETs), the vertical FET 20 in effect acts as an amplifier, amplifying the electrical signal ($i \times R_G$) produced by the photodiode 110 in response to the incident light signal. Thus, the photo-FET 100 is, in fact, an amplifier, producing a relatively large voltage signal $V_{out}$, i.e., a relatively large drop in voltage, in response to a relatively small light signal.

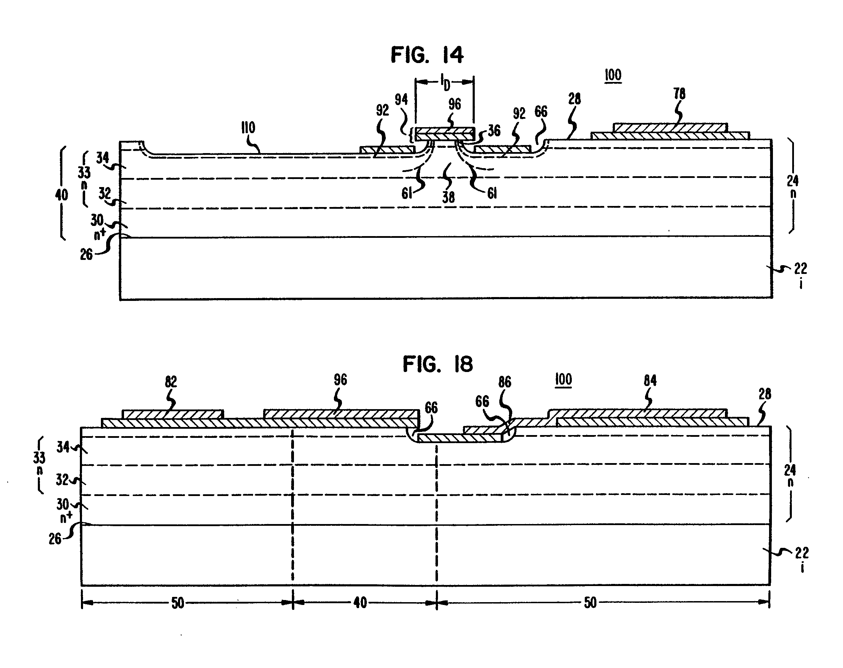

In a second embodiment of the photo-FET 100, shown in FIGS. 13, 14 and 18, a p-n junction photodiode 110 is coupled to, and integrated with, the second embodiment of the vertical FET 20. The p-n junction photodiode is formed by lithographically delineating the gate metal area 72 and photodiode area 112 (after the formation of the drain electrode 96) and then diffusing an opposite-conductivity dopant into both the gate metal area 72 and the photodiode area 112. Thereafter, just the gate metal area 72 is delineated and metallized to complete the formation of the gate electrodes 92.

If, for example, the semiconductor body 24 of the second embodiment of the photo-FET 100 is of GaAs doped with Si, then the opposite-conductivity dopant diffused into the photodiode area 112 is, for example, zinc. The penetration depth of the zinc ranges from about 50 to 150 nm, and is preferably about 100 nm. The p-n junction photodiode 110 formed as a result of the zinc diffusion is at least partially transparent (at least 50 percent of the incident light penetrates the photodiode 110) to infrared light, i.e., light having a wavelength ranging from about 800 nm to about 1500 nm. A penetration depth of the zinc less than about 50 nm is undesirable because uniformity of penetration depth is difficult to achieve. On the other hand, a penetration depth of the zinc greater than about 150 nm is undesirable because the zinc diffuses both laterally and vertically, and thus the thickness of the vertical current channel is undesirably reduced and channel resistance undesirably increased.

The operation of the second embodiment of the photo-FET 100 differs from the operation of the first embodiment only in that in the normally-off mode of operation, for example, it is the single source pad 78 which is grounded, and the positive supply voltage $V_{DD}$ which is applied to the drain pad 82.

In each of the Examples below, a GaAs wafer was processed, in accordance with the invention, to produce approximately 1000 vertical FETs, encompassed by the invention. For the sake of convenience, the descriptions given below refer to the fabrication of a single vertical FET, it being understood that the described procedure was, in fact, applied to the whole wafer to simultaneously produce all 1000 vertical FETs. In addition, for the sake of clarity and continuity, the numerals used above to denote the components of the inventive vertical FET 20 are also used below to denote these same components.

## Example 1

The first embodiment of the inventive vertical FET 20 was fabricated by initially growing a drain layer 30, an active layer 33, and a contact layer 36 on a semi-insulting 5.1 cm, (2-inch) wafer of Cr-doped GaAs (doped to a level of about 1 x $10^{15} cm^{-3}$) purchased from the Morgan Semiconductor Company of Texas. The layers 30, 33, and 36 were each of Si-doped GaAs, and each was epitaxially grown by conventional molecular beam epitaxy (MBE) techniques. The doping level of each of the layers 30, 33, and 36 was, respectively, about 1 x $10^{18} cm^{-3}$, about 1 x $10^{15} cm^{-3}$, and about 1 x $10^{18} cm^{-3}$, while the thickness of each of these layers was, respectively, about 1 $\mu m$, about 3.5 $\mu m$, and about 0.2 $\mu m$.

The surface of what was to become the active region 40 of the vertical FET 20 was delineated and overlaid with layers of photoresist and gold by initially spin-coating a first layer of AZ 1350J Shipley positive photoresist, about 1 $\mu m$-thick, onto the surface of the contact layer 36. A 2 $\mu m$-thick layer of gold was then evaporated onto the first layer of photoresist, and a second layer of AZ 1350J positive photoresist, about 2 $\mu m$ thick, was then spin-coated onto the upper surface of the gold layer. The upper (second) layer of photoresist was then exposed to shallow UV light (of wavelength approximately equal to 400 nm) through a contact mask which covered and outlined what was to become the active region 40. The contact mask was z-shaped in outline (in order to produce a z-shaped active region 40, as in FIG. 6) and included a central, rectangular area which was about 75 $\mu m$ in length and about 25 $\mu m$ in width, as well as two rectangular areas (at opposite ends of the central area) each of which was about 50 $\mu m$ in length and about 50 $\mu m$ in width. Shipley AZ developer was then used to develop the upper, exposed layer of photoresist, and Argon ions having energies of about 500 eV were then used to mill away the uncovered portions of the gold layer (the portions no longer covered by the exposed and developed upper layer of photoresist). The entire upper surface of the photoresist-and-gold-covered wafer was then again exposed to shallow UV light, and the remainder of the upper (second) photoresist layer as well as the portions of the lower (first) photoresist layer not covered by the gold layer were then developed with the Shipley AZ developer. Thus, the surface of the active region 40 was covered and outlined by successive layers of photoresist and gold.

The wafer was then twice implanted with $O^{-1}$ ions, the ions penetrating into the inactive region 50 (see FIG. 6) but not penetrating into the photoresist-and-gold-covered active region 40. The first implant involved $O^{-1}$ ions having energies of about 700 keV, implanted at a dosage of about 2 x $10^{12} cm^{-2}$. The second implant involved $O^{-1}$ ions having energies of about 3 MeV implanted at a dosage of about 2 x $10^{13} cm^{-2}$. A chemical etchant comprised of a 30 present solution of $H_2O_2$ in water, having a pH of about 7.2, was then applied to the upper surface of the wafer. The pH was adjusted by adding $NH_4OH$. This etchant was used to etch the upper surface of the inactive region 50 (the photoresist and gold shielding the active region 40 from the etchant) down about 100 nm below the upper surface of the active region 40 in order that the two regions could be distinguished during subsequent processing. An acetone spray was then used to dissolve the photoresist covering the wafer, resulting in the simultaneous removal of the layer of gold overlying the photoresist.

A 2$\mu m$-thick layer of AZ 1350J Shipley positive photoresist was again spin-coated onto the wafer. The photoresist was then exposed to shallow UV light through a contact mask which covered the surface of the wafer except for the areas to be occupied by the source electrode 56, the two drain pads 78, the source pad 82, and the gate pad 84. (The areas to be occupied by the source electrode and drain pads were on the surface of the active region 40, while the areas to be occupied by the source pad and gate pad were on the surface of the inactive region 50, as shown in FIG. 6.) The outlined source electrode area was about 25 $\mu m$ in length and about 1.5 $\mu m$ in width and extended into contact with the source pad area. Each of the outlined drain pad, source pad, and gate pad areas was about 50 $\mu$m in length by about 50 $\mu$m in width. The exposed photoresist was then developed with the AZ developer.

Successive layers of an AU-Ge alloy having about 27 atomic percent Ge, Ag, and Au were then evaporated onto the upper surface of the photoresist-covered wafer falling through the openings in the photoresist to form a metallized source electrode 56 integrally connected to a metallized source pad 82, as well as two metallized drain pads 78 and a metallized gate pad 84. The thickness of each of these layers of metal was, respectively, about 40 nm, about 100 nm, and about 150 nm. The photoresist still covering the wafer was then removed with an acetone spray, the layers of metal covering the photoresist being simultaneously removed.

The metallized source electrode 56, the two metallized drain pads 78, the metallized source pad 82 and the metallized gate pad 84 were then alloyed at a temperature of about 420°C for about 15 seconds in a helium atmosphere. The alloying produced ohmic contacts at the source electrode 56 and at the drain pads 78, and served to adhere the source pad 82 and the gate pad 84 to the underlying semiconductor material.

A gate metal area 72 (see FIG. 6) on the surface of the active region 40 was then delineated by spin-coating a 2 $\mu$m-thick layer of the AZ positive photoresist onto the wafer. The photoresist was then exposed to shallow UV light through a contact mask which covered the surface of the wafer except for the gate metal area 72. The photoresist was then developed using the AZ developer, thereby opening a window in the photoresist and uncovering the gate metal area 72, whose dimensions were about 25 $\mu$m in length by about 25 $\mu$m in width. As shown in FIG. 6, the gate metal area 72 extended beyond the active region 40 into portions of the inactive region 50, encompassing a portion of the metallized source pad 82 as well as a portion of the active region 40 adjacent the metallized gate pad 84. The above-described $H_2O_2$ etchant was then applied to the wafer, etching only the uncovered gate metal area 72. This etching generally isotropically etches GaAs but does not etch the metal of the metallized source electrode 56 and the metallized contact pads. Thus, two channels 66 were etched into the GaAs on the opposite sides of the source electrode 56, which channels undercut the sides of the source electrode. The etchant was applied for about three minutes producing channels having a depth of about 0.3 $\mu$m.

In order to produce metallized, Schottky-barrier gate electrodes 2 within the etched channels 66, successive layers of Pt, Ti, Pt, and Au were then evaporated onto the surface of the wafer, and thus into the uncovered gate metal area 72, falling onto the source electrode 56 as well as into the channels 66. The thicknesses of these layers were, respectively, about 5 nm, about 50 nm, about 50 nm, and about 100 nm.

A metallic interconnection between the gate pad 84 and the gate electrodes 62, denoted by the numeral 86 in FIG. 6, was then formed, and the contact pads were thickened, by first spin-coating a 2 $\mu$m-thick layer of the AZ 1350J positive photoresist onto the upper surface of the wafer, and then exposing the photoresist to shallow UV light through a contact mask which covered the surface of the wafer except for the interconnect area as well as the drain, source, and gate pads. The photoresist was then developed using the AZ developer, and successive layers of Pt, Ti, Pt, and Ag were then evaporated onto the surface of the wafer, metallizing the interconnect area and thickening the contact pads. The photoresist was then removed with an acetone spray, simultaneously removing the layers of metal covering the photoresist.

A protective, 400 nm-thick layer of silicon nitride was then deposited onto the surface of the wafer by plasma enhanced chemical vapor deposition, using $SiH_4$ and $NH_3$ as the reactant gases and $Ar_2$ as the carrier gas, in order to prevent mechanical and environmental damage to the fabricated vertical FET 20. A 2 $\mu$m-thick layer of the positive photoresist was then spin-coated onto the wafer and the photoresist was exposed to shallow UV light through a contact mask which covered everything but the contact pads. The photoresist was then developed with the AZ developer and the silicon nitride covering the contact pads was then etched with a plasma comprised of $CF_4$ and 10 percent (by volume) $O_2$. An acetone spray was then used to remove the remaining photoresist, and gold wires were then bonded to the contact pads.

The inherent surface potential associated with the doped GaAs of the fabricated vertical FET 20 was found to be sufficient to pinch off the current channel 38 of the FET without any application of a negative voltage to the gate electrodes 62, and thus this FET was inherently a normally-off FET.

The operating characteristics of the normally-off FET 20 were measured using conventional techniques. From the resulting data it was determined that the transconductance, $g_m$, of the FET 8mS/mm. Moreover, the voltage amplification factor, $\mu$ (defined as the ratio of the change in drain-to-source voltage to a change in gate-to-source voltage at constant drain-to-source current), was found to be 15.

## Example 2

A vertical FET 20 having a vertical dopant concentration gradient within its active layer was fabricated. The fabrication procedure was identical to that used in fabricating the FET of Example 1, with the exception that two layers of Si-doped GaAs were epitaxially grown, by conventional MBE techniques, in place of the single, active layer 33. The first layer, denoted by the numeral 32 in Fig. 7, had a thickness of about 3.5 $\mu$m and a doping level of about $1 \times 10^{15} cm^{-3}$. The second layer, denoted by the numeral 34 in FIG. 7, had a thickness fo about 0.8 $\mu$m and a doping level of about $1 \times 10^{16} cm^{-3}$. It was determined that the increased doping level within the active layer produced a surface potential which was now insufficient to pinch off the current channel 38 without the application of a negative voltage to the gate electrodes 62, and thus this FET was a normally-on FET.

The operating characteristics of the normally-on FET were measured using conventional techniques. It was found that the current channel of this FET was pinched off by applying a voltage of -1 volts (relative to the grounded source pad) to the gate pad. The transconductance, $g_m$, was determined to be 20 mS/mm, while the voltage amplification factor, $\mu$, was found to be 1.8. Thus, while the FET of Example 1 is a relatively good voltage amplifier (because it exhibits a relatively high voltage amplification factor), the FET of Example 2 is a relatively good current amplifier (because it exhibits a relatively high transconductance).

## Claims

1. 1. A field effect transistor, comprising:
a semiconductor body which includes a first major surface, a non-coplanar second major surface, and a relatively heavily doped portion immediately adjacent said second major surface; and
three electrodes on said first major surface of said semiconductor body, a first of which is positioned between the second and third of said electrodes, the second and third electrodes forming rectifying contacts with the underlying semiconductor material and constituting the gate electrodes of said field effect transistor, a current channel extending between said first electrode and said relatively heavily doped portion,
CHARACTERIZED IN THAT
said current channel is of uniform conductivity type and includes a material region having a dopant concentration greater than about $1 \times 10^{15} cm^{-3}$,
said semiconductor body includes first and second regions which extend from said first major surface toward said second major surface, the electrical resistivity of said second region being greater than the electrical resistivity of said first region, said three electrodes being arranged on said first region, and
said field effect transistor further comprising first, second, and third contact pads arranged on said first major surface, said first contact pad being arranged on said second region and being electrically connected to said first electrode, said second contact pad being arranged on said second region and being electrically connected to said gate electrodes, and said third contact pad being arranged on said first region.

2. Apparatus in accordance with claim 1, CHARACTERIZED IN THAT
said gate electrodes are metallized gate electrodes which are arranged in channels etched into said first major surface on the opposite sides of said first electrode; and
said channels and said gate electrodes are formed by a method which includes the steps of etching and metallizing a delineated area on said first major surface, which delineated area includes the area occupied by said first electrode, said first electrode shielding the underlying semiconductor material during said etching and metallizing steps.

3. Apparatus in accordance with claim 1, CHARACTERIZED IN THAT
said gate electrodes are p-n junction gate electrodes which are arranged in channels etched into said first major surface on the opposite sides of said first electrode; and
said channels and said gate electrodes are formed by a method which includes the steps of etching and doping with an opposite-conductivity dopant a delineated area on said first major surface, which delineated area includes the area occupied by said first electrode, said first electrode shielding the underlying semiconductor material during said etching and doping steps.

4. Apparatus in accordance with claim 2 or 3, CHARACTERIZED IN THAT
said channels undercut said first electrode.

5. Apparatus in accordance with claim 2, CHARACTERIZED IN THAT
said first electrode is a metallized source electrode, the relatively heavily doped portion immediately adjacent said second major surface constituting the drain of said field effect transistor.

6. Apparatus in accordance with claim 5, CHARACTERIZED IN THAT
a photodiode is electtrically connected to said gate electrodes, said photodiode including a layer of metal on said first major surface on said first region, which layer of metal forms a rectifying contact with the underlying semiconductor material and which is at least partially transparent to electromagnetic radiation.

7. Apparatus in accordance with claim 6,
CHARACTERIZED IN THAT
said layer of metal extends continuously from the metal of one of said gate electrodes.

8. Apparatus in accordance with claim 3,
CHARACTERIZED IN THAT
said first electrode is a metallized drain electrode, the relatively heavily doped portion immediately adjacent said second major surface constituting the source of said field effect transistor.

9. Apparatus in accordance with claim 8,
CHARACTERIZED IN THAT
a photodiode is electrically connected to said gate electrodes, said photodiode including an area on said first major surface on said first region doped with an opposite-conductivity dopant to form a p-n junction, which p-n junction is at least partially transparent to electromagnetic radiation.

10. Apparatus in accordance with claim 9,
CHARACTERIZED IN THAT
the p-n junction of said photodiode extends continuously from the p-n junction of one of said p-n junction gate electrodes.

11. Apparatus in accordance with claim 1,
CHARACTERIZED IN THAT
the resistivity of said second region is at least 10,000 times greater than that of said first region.

12. Apparatus in accordance with claim 11,
CHARACTERIZED IN THAT
said second region is an ion implanted region.

13. Apparatus in accordance with claim 5,
CHARACTERIZED IN THAT
said semiconductor body further includes a relatively heavily doped potion immediately adjacent said first major surface and lying immediately beneath said source electrode, said source electrode and the underlying semiconductor material of the adjacent heavily doped portion defining the source of said field effect transistor, the active layer of said field effect transistor being sandwiched between said relatively heavily doped portion.

14 Apparatus in accordance with claim 8,
CHARACTERIZED IN THAT
said semiconductor body further includes a relatively heavily doped portion immediately adjacent said first major surface and lying immediately beneath said drain electrode, said drain electrode and the underlying semiconductor material of the adjacent heavily doped portion defining the drain of said field effect transistor, the active layer of said field effect transistor being sandwiched between said relatively heavily doped portions.

15. Apparatus in accordance with claim 13 or 14,
CHARACTERIZED IN THAT

said semiconductor body further includes a dopant concentration gradient within said active layer, said dopant concentration gradient being oriented along a direction extending between said source and drain.

16. Apparatus in accordance with claim 15,
CHARACTERIZED IN THAT
said active layer includes two layers having different dopant concentrations.

17, Apparatus in accordance with claim 12,
CHARACTERIZED IN THAT
said semiconductor body is of n-type conductivity.

18 Apparatus in accordance with claim 17,
CHARACTERIZED IN THAT
said semiconductor body is GaAs doped with an n-type conductivity dopant.

19. Apparatus in accordance with claim 18,
CHARACTERIZED IN THAT
said n-type conductivity dopant is silicon.

20. Apparatus in accordance with claim 19,
CHARACTERIZED IN THAT
said second region is implanted with oxygen ions.

21. Apparatus in accordance with claim 19 or 20,
CHARACTERIZED IN THAT
said second region is implanted with hydrogen ions.

22. Apparatus in accordance with claim 13,
CHARACTERIZED IN THAT
said semiconductor body is of GaAs doped with silicon;
said source electrode includes successive layers of a gold-germanium alloy, silver, and gold; and
the metal deposited onto said delineated area to form said gate electrodes includes successive layers to platinum, titanium, platinum, and gold.

23. Apparatus in accordance with claim 14,
CHARACTERIZED IN THAT
said semiconductor body is of GaAs doped with silicon;
said drain electrode is of tungsten; and
said opposite conductivity dopant doped into said delineated area to form said p-n junction gate electrodes is zinc.

24. Apparatus in accordance with claim 1,
CHARACTERIZED BY
further comprising a body which includes insulating or semi-insulating material, said second major surface defining an interface between said semiconductor body and the body which includes insulating or semi-insulating material.

25. Apparatus in accordance with claim 24,
CHARACTERIZED IN THAT
said second region extends from said first major surface substantially to said second major surface.

26. A method for fabricating a field effect transistor, comprising the steps of:
defining first and second regions in a semiconductor body, which first and second regions extend from a first major surface toward a non-coplanar second major surface of said semiconductor body, said semiconductor body including a relatively heavily doped portion immediately adjacent said second major surface; and

producing three electrodes on said first major surface on said first region, a first fo the three electrodes being positioned between the second and third electrodes, said second and third electrodes forming rectifying contacts with the underlying semiconductor material and constituting the gate electrodes of said field effect transistor, a current channel extending between said first electrode and said relatively heavily doped portion, CHARACTERIZED IN THAT

said defining step includes the step fo implanting ions into said second region in order to increase the electrical resistivity of said second region above that of said first region, and

said producing step includes the step of forming first, second, and third contact pads on said first major surface, said first contact pad being formed on said second region and being electrically connected to said first electrode, said second contact pad being formed on said second regions and being electrically connected to said gate electrodes, and said third contact pad being formed on said first region.

27. The method in accordance with claim 26, CHARACTERIZED IN THAT

said producing step further includes the step of etching and metallizing a delineated area on said first major surface, which delineated area includes the area occupied by said first electrode, said first electrode shielding the underlying semiconductor material during said etching and metallizing steps which results in the formation of two metallized steps which the opposite sides of said source electrode, the metallized channels constituting the gate electrodes.

28. The method in accordance with claim 26, CHARACTERIZED IN THAT

said producing step further includes the steps of etching and doping with an opposite-conductivity dopant a delineated area on said first major surface, which delineated area includes the area occupied by said first electrode, said first electrode shielding the underlying semiconductor material during said etching and doping steps which results in the formation of two p-n junctions in channels on the opposite sides fo said first electrode, the p-n junctions constituting the gate electrodes.

29. The method in accordance with claim 27 or 28, CHARACTERIZED IN THAT

said channels undercut said first electrode.

FIG. 1

GATE PAD

SOURCE
ELECTRODE

DRAIN ELECTRODE

2

2

DRAIN PAD

SOURCE PAD

GATE
ELECTRODE

MESA

FIG. 2

SOURCE ELECTRODE

GATE ELECTRODE

DRAIN ELECTRODE

SOURCE PAD

MESA

DRAIN PAD

SEMI-INSULATING LAYER

GATE ELECTRODE

DEPLETION
REGION

SOURCE ELECTRODE
DEPLETION REGION

GATE ELECTRODE

FIG. 3

DRAIN ELECTRODE

FIG. 4

GATE PAD

DRAIN PAD

GATE ELECTRODE

MESA

SOURCE ELECTRODE

SOURCE PAD

FIG. 5

GATE ELECTRODE    SOURCE ELECTRODE

GATE ELECTRODE

MESA

DRAIN PAD

DOPED (DRAIN) REGION

SEMI-INSULATING LAYER

FIG. 12

$V_{DD}$

$R_L$

110

84    78    $V_{OUT}$

82

$R_G$

$-V_{GG}$

FIG. 6

0 252 173

FIG. 7

FIG. 15

0 252 173

F/G. 8

# FIG. 9

# FIG. 16

0 252 173

FIG. 10

FIG. II

FIG. I7

FIG. 13

FIG. 14

FIG. 18

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 343 015 (BALIGA et al.) <br><br> * Whole document * <br><br> --- | 1-5,8, 11-14, 17-19, 21-29 | H 01 L 29/80 <br> H 01 L 29/64 <br> H 01 L 29/52 <br> H 01 L 29/10 <br> H 01 L 21/76 <br> H 01 L 21/265 <br> H 01 L 21/28 |
| A | DE-A-3 417 959 (LICENTIA PATENT-VERWALTUNGS-GmbH) <br><br> * Page 5, lines 6-30; figure 1 * <br><br> --- | 1,11, 12,17- 19,24, 26 | H 01 L 27/14 <br> H 01 L 29/56 |
| A | IEEE TRANSACTIONS ON ELECTRON DEVICES, vol. ED-32, no. 5, May 1985, pages 952-956, IEEE, New York, US; W.R. FRENSLEY et al.: "Design and fabrication of a GaAs vertical MESFET" <br> * Page 952, column 2; page 954, paragraph IV: "Fabrication proce- dure; figure 1 * <br><br> --- | 1,2,4, 5,13, 17-19, 22,24, 26,27, 29 | **TECHNICAL FIELDS SEARCHED (Int. Cl.4)** <br><br> H 01 L |
| A | US-A-4 015 278 (FUKUTA) <br><br> * Column 4, line 57 - column 6, line 50; figures 2D,4 * <br><br> ---     -/- | 1-5,8, 13,14, 17-19, 22,24, 27-29 | |

The present search report has been drawn up for all claims

| Place of search | Date of completion of the search | Examiner |
|---|---|---|
| THE HAGUE | 11-03-1987 | MORVAN D.L.D. |

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| A | WO-A-8 303 708 (WESTERN ELECTRIC CO.) * Figures 3,4 * | 6,7,9 | |
| A | IBM TECHNICAL DISCLOSURE BULLETIN, vol. 25, no. 12, May 1983, pages 6418-6420, New York, US; T.N. JACKSON: "Vertical short gate FET structure" * Whole document * | 1,2,8, 11,12, 14,17- 21,26, 27 | |
| A | FR-A-2 534 416 (THOMSON-CSF) | | |

TECHNICAL FIELDS SEARCHED (Int. Cl.4)

The present search report has been drawn up for all claims

| Place of search | Date of completion of the search | Examiner |
|---|---|---|
| THE HAGUE | 11-03-1987 | MORVAN D.L.D. |